# EUROPEAN PATENT APPLICATION

(11) **EP 4 697 914 A1**
(43) Date of publication of application: **18.02.2026**
(21) Application number: 23945668.4
(22) Date of filing: 21.11.2023
(51) Int. Cl.: H10K 59/122

(54) **DISPLAY PANEL AND DISPLAY APPARATUS**

(30) Priority: 18.07.2023 CN 202310887522
(71) Applicant: Wuhan China Star Optoelectronics Semiconductor Display Technology Co., Ltd., Wuhan, Hubei 430079 (CN)
(72) Inventor: CHEN, Chen, Wuhan, Hubei 430079 (CN); ZHANG, Qipei, Wuhan, Hubei 430079 (CN); ZHAO, Yu, Wuhan, Hubei 430079 (CN); KIM, Gunmo, Wuhan, Hubei 430079 (CN)
(74) Representative: Zhu, Puxing
(86) International application number: PCT/CN2023/132798
(87) International publication number: WO 2025/015788

(57) **Abstract**

The present application provides a display panel and a display apparatus. The display panel includes a display functional layer, which includes a dam structure including dam layers. The dam structure includes a protruding sub-region and a recessed sub-region connected to each other, and the dam layers are disposed in both the recessed sub-region and the protruding sub-region; the number of the dam layers in the recessed sub-region is greater than or equal to 1 and less than the number of the dam layers in the protruding sub-region, and the height of the dam structure in the recessed sub-region is less than the height of the dam structure in the protruding sub-region.

## Description

### TECHNICAL FIELD

The present application relates to the field of display technologies, and in particular, to a display panel and a display apparatus.

### BACKGROUND

Organic light-emitting diode (OLED) display technology is a self-emissive display technology that does not require a backlight and offers advantages such as high brightness, low power consumption, wide viewing angles, and high response speed. It is currently widely used in the mobile phone display panel industry. In addition to the display surface, the display panel also includes components such as cameras and other sensors, which occupy a significant portion of the screen-to-body ratio. How to effectively increase the screen-to-body ratio of the display surface and enhance the aesthetic appeal of the display panel has become the mainstream focus in current design trends.

Holes are provided in the screen corresponding to the sensor components to improve light transmittance. However, when the organic layer of the screen extends to the periphery of the hole, it creates a pathway for moisture intrusion, allowing moisture to penetrate from the hole into the screen, thereby affecting the performance and stability of the device.

Currently, multiple rings of dams are often provided around the hole to prevent the extension of the organic layer. However, these multiple rings of dams occupy a significant amount of space, increasing the area of the region corresponding to the sensor components and reducing the screen-to-body ratio of the display surface.

### SUMMARY

Embodiments of the present application provide a display panel and a display apparatus, which can reduce the width of the dam structure, thereby reducing the width of the transition region and increasing the screen-to-body ratio of the display panel.

The embodiments of the present application provide a display panel, which includes a display region, a sensor photosensitive region, and a transition region located between the display region and the sensor photosensitive region;
the display panel further includes:
a substrate; and
a display functional layer disposed on the substrate, where the display functional layer includes a display portion disposed in the display region and a dam structure disposed in the transition region, and the dam structure includes dam layers;
where the dam structure includes a protruding sub-region and a recessed sub-region connected to each other, and the dam layers are disposed in both the recessed sub-region and the protruding sub-region; the number of the dam layers in the recessed sub-region is greater than or equal to 1 and less than the number of the dam layers in the protruding sub-region, and a height of the dam structure in the recessed sub-region is less than a height of the dam structure in the protruding sub-region.

According to the above object of the present application, the embodiments of the present application further provide a display apparatus, which includes a display panel. The display panel includes a display region, a sensor photosensitive region, and a transition region located between the display region and the sensor photosensitive region;
the display panel further includes:
a substrate; and
a display functional layer disposed on the substrate, where the display functional layer includes a display portion disposed in the display region and a dam structure disposed in the transition region, and the dam structure includes dam layers;
where the dam structure includes a protruding sub-region and a recessed sub-region connected to each other, and the dam layers are disposed in both the recessed sub-region and the protruding sub-region; the number of the dam layers in the recessed sub-region is greater than or equal to 1 and less than the number of the dam layers in the protruding sub-region, and a height of the dam structure in the recessed sub-region is less than a height of the dam structure in the protruding sub-region.

### BRIEF DESCRIPTION OF THE DRAWINGS

FIG. 1 is a schematic diagram of a structure of a display panel provided in the related art.
FIG. 2 is a schematic diagram of a structure of a display panel according to some embodiments of the present application.
FIG. 3 is a schematic diagram of a planar distribution of the display panel according to some embodiments of the present application.
FIG. 4 is a schematic diagram of a structure of a dam structure according to some embodiments of the present application.
FIG. 5 is another schematic diagram of the structure of the dam structure according to some embodiments of the present application.
FIG. 6 is another schematic diagram of the structure of the dam structure according to some embodiments of the present application.
FIG. 7 is another schematic diagram of the structure of the dam structure according to some embodiments of the present application.
FIG. 8 is another schematic diagram of the structure of the dam structure according to some embodiments of the present application.
FIG. 9 is a schematic structural diagram of a manufacturing process of the dam structure according to some embodiments of the present application.
FIG. 10 is another schematic diagram of the structure of the dam structure according to some embodiments of the present application.
FIG. 11 is another schematic diagram of the structure of the dam structure according to some embodiments of the present application.
FIG. 12 is a schematic diagram of a structure of a display apparatus according to some embodiments of the present application.

### DETAILED DESCRIPTION

The technical solutions in the embodiments of the present application will be clearly and completely described with reference to the accompanying drawings of the present application. Apparently, the described embodiments are only some of the embodiments of the present application, rather than all of the embodiments. According to the embodiments of the present application, all other embodiments obtained by those skilled in the art without making creative efforts shall fall within the scope of protection of the present application.

Various embodiments and examples are provided in the following description to implement different structures of the present application. In order to simplify the present application, components and settings of specific embodiments will be described below. It should be understood that the examples are merely for description and are not intended to limit the present application. Further, in the present application, reference numerals and reference letters may be repeated in different examples, which is for purposes of simplicity and clarity and does not indicate a relationship of the various embodiments and/or the settings. Furthermore, the present application provides specific examples of various processes and materials, however, applications of other processes and/or other materials may be appreciated by those skilled in the art.

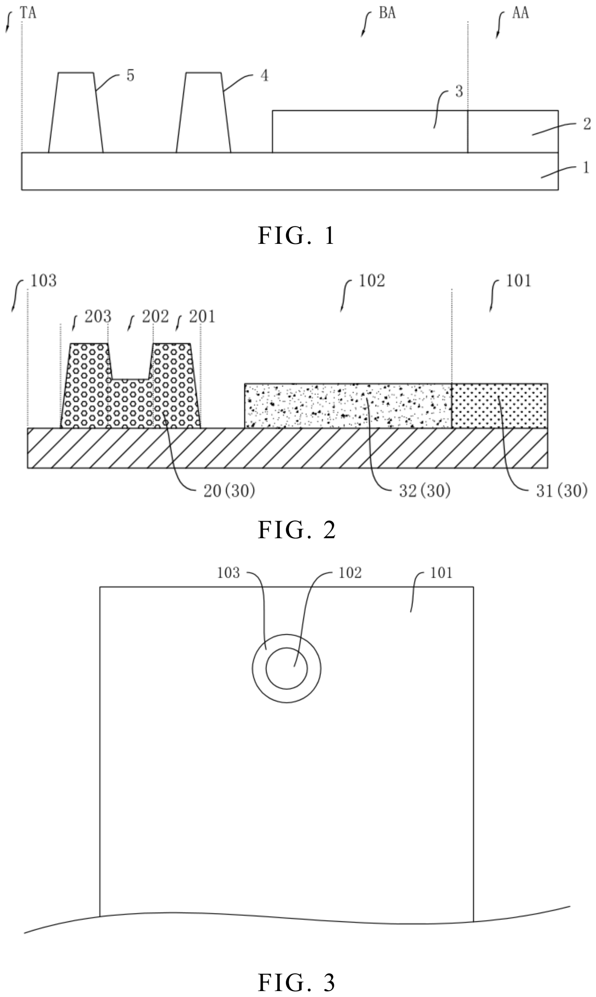

Referring to FIG. 1, the display panel includes a substrate 1, a display device layer 2, and a driving circuit 3 that are disposed on the substrate 1, as well as a display region AA, a bezel region BA, and a light-transmitting region TA. Devices such as cameras are disposed corresponding to the light-transmitting region AA to achieve multi-functionalization of the display panel. Therefore, an opening is often provided in the light-transmitting region TA of the display panel to improve light transmittance. To prevent the formation of moisture intrusion channels at the sidewall of the opening in the organic layer of the encapsulation layer, multiple dams are typically disposed within the bezel region BA surrounding the light-transmitting region TA; for example, a first dam 4 and a second dam 5. It should be noted that the first dam 4 and the second dam 5 are formed together with part of the film layers in the display device layer 2, meaning that each of the first dam 4 and the second dam 5 is composed of multiple stacked film layers, obtained through the photolithography process of each film layer. However, due to the large number of film layers in the first dam 4 and the second dam 5, and the need to account for precision fluctuations in the photolithography process for each film layer, a certain width must be reserved between the first dam 4 and the second dam 5 to buffer the impact of precision fluctuations in the photolithography process. Generally, the distance between the first dam 4 and the second dam 5 ranges from 25 µm to 30 µm. This necessitates reserving a relatively wide space in the bezel region BA to set the dams, thereby increasing the width of the bezel region BA and reducing the screen-to-body ratio of the display panel.

Referring to FIG. 2 and FIG. 3, some embodiments of the present application provide a display panel, which includes a display region 101, a sensor photosensitive region 102, and a transition region 103 disposed between the display region 101 and the sensor photosensitive region 102.

Further, the display panel further includes a substrate 10 and a display functional layer 30. The display functional layer 30 is disposed on the substrate 10. The display functional layer 30 includes a display portion 31 disposed in the display region 101 and a dam structure 20 disposed in the transition region 103. The dam structure 20 includes dam layers.

The dam structure 20 includes a protruding sub-region 201 and a recessed sub-region 202 connected to each other. The dam layers are disposed in both the recessed sub-region 202 and the protruding sub-region 201. The number of dam layers in the recessed sub-region 202 is greater than or equal to 1 and less than the number of dam layers in the protruding sub-region 201. The height of the dam structure 20 in the recessed sub-region 202 is less than the height of the dam structure 20 in the protruding sub-region 201.

**In** the implementation and application process, the embodiments of the present application differentiate the number of dam layers within the protruding sub-region 201 and the recessed sub-region 202 of the dam structure 20. It selectively removes part of the dam layers within the recessed sub-region 202 to form a concave-convex morphology in the dam structure 20. This allows the dam structure 20 to provide a blocking effect on the film layer material that is comparable to the blocking effect of more than one dam in related art. At the same time, in the embodiments of the present application, part dam layers in the dam structure 20 can be etched to selectively remove certain dam layers within the recessed sub-region 202. Compared to related art, this approach does not require etching all the film layers, reducing the number of etching processes and thereby minimizing the impact of precision fluctuations in the etching process. This eliminates the need to reserve a large space to buffer the impact of etching process precision fluctuations, allowing for a reduction in the width of the recessed sub-region 202 and the width of the dam structure 20, which in turn reduces the width of the transition region 103 and increases the screen-to-body ratio of the display panel.

In an embodiment of the present application, the dam layer includes a first dam layer, a second dam layer, and a third dam layer that are arranged in a stacked configuration, and the first dam layer is provided with a first opening located in the recessed sub-region.

In an embodiment of the present application, the first dam layer is disposed between the substrate and the second dam layer, and the third dam layer is disposed on a side of the second dam layer away from the first dam layer; the second dam layer and/or the third dam layer covers the first opening.

In an embodiment of the present application, the second dam layer is provided with a second opening located in the recessed sub-region and communicated with the first opening, and the third dam layer covers both the first opening and the second opening.

Alternatively, the second dam layer covers the first opening, and the third dam layer is provided with a third opening disposed on a side of the second dam layer that is away from the substrate and located in the recessed sub-region.

Alternatively, both the second dam layer and the third dam layer cover the first opening.

In an embodiment of the present application, the first dam layer is disposed on a side of the second dam layer away from the third dam layer, the third dam layer is disposed between the substrate and the second dam layer, and at least the third dam layer is spaced between the first opening and the substrate.

In an embodiment of the present application, the second dam layer is provided with a second opening that is located in the recessed sub-region and communicated with the first opening.

**In** an embodiment of the present application, the first dam layer is disposed between the second dam layer and the third dam layer, and the second dam layer is disposed between the substrate and the first dam layer.

**In** an embodiment of the present application, the first dam layer includes a plurality of sub-layers arranged in a stacked configuration, and the first opening passes through part or all of the plurality of sub-layers.

**In** an embodiment of the present application, the display panel is provided with a light-transmitting hole in the sensor photosensitive region, the dam structure includes at least two of the protruding sub-regions, and the recessed sub-region is disposed between adjacent protruding sub-regions; the dam structure is disposed around the light-transmitting hole, and the recessed sub-region is also disposed around the light-transmitting hole.

**In** an embodiment of the present application, the display panel further includes an encapsulation layer, which includes at least two inorganic encapsulation sub-layers and an organic encapsulation sub-layer disposed between two adjacent inorganic encapsulation sub-layers.

The coverage boundary of the organic encapsulation sub-layer is located within the recessed sub-region, or within the protruding sub-region, or at a side of the dam structure that is away from the light-transmitting hole.

Specifically, referring further to FIG. 2 and FIG. 3, in some embodiments of the present application, the display panel includes the display region 101, the sensor photosensitive region 102, and the transition region 103. The display region 101 is the region of the display panel where images are shown, while the sensor photosensitive region 102 is the region of the display panel designated for placing sensors, such as cameras. The transition region 103 is located between the display region 101 and the sensor photosensitive region 102.

It should be noted that the display panel includes a light-transmitting hole disposed in the sensor photosensitive region 102. The light-transmitting hole can effectively improve the light transmittance of the display panel in the sensor photosensitive region 102 to improve the sensing effect of the sensor. Additionally, the transition region 103 is disposed around the light-transmitting hole and can be regarded as the bezel region of the light-transmitting hole.

Further, the display panel further includes the substrate 10 and the display functional layer 30 that is disposed on the substrate 10. The display functional layer 30 includes the display portion 31 located in the display region 101, the driving circuit unit 32 located in the transition region 103, and the dam structure 20.

In an embodiment, the light-transmitting hole may pass through at least part of the substrate 10 and at least part of the display functional layer 30, which may be specifically selected according to actual light transmittance requirements and is not limited herein.

The display portion 31 includes a thin film transistor array layer, a planarization layer, a pixel definition layer, a photo spacer (PS), an anode layer, an organic light-emitting layer, and a cathode layer that are disposed in the display region 101. The driving circuit unit 32 may include a circuit structure composed of thin film transistor devices, signal traces, and capacitors that are disposed in the transition region 103, and may be connected to the display portion 31.

The dam structure 20 is disposed at a side of the driving circuit unit 32 that is away from the display portion 31. It should be noted that the display panel further includes an encapsulation layer (not shown in the figures) disposed on a side of the display functional layer 30 that is away from the substrate 10. The encapsulation layer includes at least two inorganic encapsulation sub-layers and an organic encapsulation sub-layer disposed between two adjacent inorganic encapsulation sub-layers. The organic encapsulation sub-layer may be made of an organic material, which can improve the flatness of the film layer of the display panel and also serve to buffer stress. However, since the organic encapsulation sub-layer does not have a water-blocking effect, it can form a pathway for moisture intrusion. To prevent the phenomenon where moisture invades the interior of the display panel through the organic encapsulation sub-layer at the light-transmitting hole in the sensor photosensitive region 102, leading to failure of the display panel, the embodiments of the present application set the dam structure 20 between the light-transmitting hole and the display portion 31, as well as between the light-transmitting hole and the driving circuit unit 32, to block the organic encapsulation sub-layer.

In the embodiments of the present application, the dam structure 20 includes the protruding sub-region 201 and the recessed sub-region 202 that are connected to each other. The height of the dam structure 20 in the recessed sub-region 202 is less than the height of the dam structure 20 in the protruding sub-region 201, creating a concave-convex topography in the dam structure 20. This design allows the dam structure 20 to provide a blocking effect on the film layer material that is comparable to the blocking effect of more than one dam in related art. At the same time, in the embodiments of the present application, the dam layers in the dam structure 20 can be etched to selectively remove certain dam layers within the recessed sub-region 202. Compared to related art, this approach does not require etching all the film layers, reducing the number of etching processes and thereby minimizing the impact of precision fluctuations in the etching process. This eliminates the need to reserve a large space to buffer the impact of etching process precision fluctuations, allowing for a reduction in the width of the recessed sub-region 202 and the width of the dam structure 20, which in turn reduces the width of the transition region 103 and increases the screen-to-body ratio of the display panel.

**In** an embodiment, the coverage boundary of the organic encapsulation sub-layer is located within the recessed sub-region 202, or within the protruding sub-region 201, or at a side of the dam structure 20 that is away from the light-transmitting hole.

**In** an embodiment, the dam structure 20 may include a plurality of protruding sub-regions 201 and a recessed sub-region 202 that is disposed between every two adjacent protruding sub-regions 201. This configuration can form grooves at the positions of the recessed sub-regions 202 in adjacent dam structures 20, thereby enhancing the blocking effect of the dam structure 20 on the organic encapsulation sub-layer.

It can be understood that both the transition region 103 and the dam structure 20 are disposed around the light-transmitting hole, and the groove formed in the recessed sub-region 202 is also disposed around the light-transmitting hole.

Further, the dam structure 20 includes at least two dam layers, that is, the dam structure 20 is formed by stacking at least two dam layers. Specifically, each dam layer can be selected to be the same film layer as some of the film layers in the display portion 31 and may be formed using the same mask. For example, a dam layer may be the same film layer as the planarization layer, the pixel definition layer, or the spacer layer in the display portion 31, and may be formed using the same mask.

It can be understood that the number of dam layers in the recessed sub-region 202 is greater than 1 and less than the number of dam layers in the protruding sub-region 201. This configuration can reduce the number of etching processes required during the formation of the dam structure 20.

In an embodiment, the number of dam layers may be greater than or equal to 3, so that the groove formed by the dam structure 20 in the recessed sub-region 202 has a certain depth, which can effectively block the organic encapsulation sub-layer.

In an embodiment, the number of dam structures 20 may be one. The embodiments of the present application achieve a similar effect on the organic encapsulation sub-layer as two dams in related art by creating a concave-convex topography within a single dam structure 20. This design further reduces the width of the transition region 103.

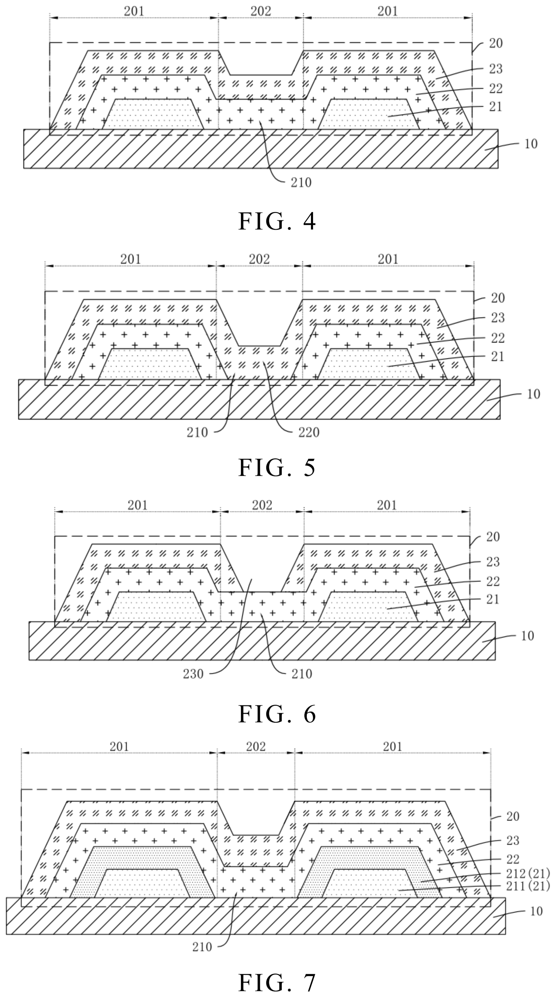

In an embodiment of the present application, referring to FIG. 2 and FIG. 4, the dam layer includes a first dam layer 21, a second dam layer 22, and a third dam layer 23 that are arranged in a stacked configuration. The first dam layer 21 is disposed between the substrate 10 and the second dam layer 22. The third dam layer 23 is disposed on a side of the second dam layer 22 that is away from the first dam layer 21. All of the first dam layer 21, the second dam layer 22, and the third dam layer 23 are disposed in the protruding sub-region 201. Both the second dam layer 22 and the third dam layer 23 are disposed in the recessed sub-region 202.

Specifically, the dam structure 20 includes two protruding sub-regions 201 and a recessed sub-region 202 disposed between the two protruding sub-regions 201.

The first dam layer 21 is provided with a first opening 210 located in the recessed sub-region 202, that is, the first dam layer 21 is partitioned in the recessed sub-region 202 to form the first opening 210 surrounding the light-transmitting hole. The second dam layer 22 and the third dam layer 23 cover both the first dam layer 21 and the first opening 210.

It should be noted that the first dam layer 21 is the lowermost layer of the dam structure 20. When both the second dam layer 22 and the third dam layer 23 cover the first opening 210, they form a groove. Since each dam layer has a certain thickness, the size of the groove may be smaller than the size of the first opening 210. In the figures of the embodiments of the present application, the division range of the recessed sub-region 202 is divided according to the groove, so the size of the first opening 210 shown in the figures will be slightly larger than the size of the recessed sub-region 202. Similarly, in subsequent embodiments, after covering the opening formed in the dam layer, if other dam layers cover the opening, it will result in the size of the groove formed in the dam structure 20 being smaller than the size of the opening.

In this embodiment, since a groove is formed in the dam structure 20, and this groove is created by removing the first dam layer 21 located in the recessed sub-region 202, only one photolithography process is needed when forming the dam structure 20. Compared with the related art shown in FIG. 1, this reduces the number of photolithography processes and minimizes the impact of fluctuations in photolithography precision. Consequently, there is no need to reserve a relatively large width for forming the groove, which reduces the width of the groove and the width of the transition region 103, thereby increasing the screen-to-body ratio of the display panel.

Optionally, the length of the first opening 210 in the direction parallel to the substrate 10 may be greater than or equal to 10 µm and less than or equal to 15 µm. Compared with the distance between the first dam 4 and the second dam 5 shown in FIG. 1, the length of the first opening 210 provided in the embodiments of the present application is effectively reduced, which can effectively reduce the width of the transition region 103.

Further, in the related art shown in FIG. 1, due to the relatively large space at both sides of the first dam 4 or the second dam 5, when the stacked film layers of the dam are formed, the material of the film layer tends to flow to two sides of the dam when forming the stacked film layers. This makes it difficult for the first dam 4 and the second dam 5 to form properly. To improve their formation stability, the related art requires increasing the widths of both the first dam 4 and the second dam 5, so that even if the film layer material flows, it can still form the protruding structure of the dams. For example, in the related art, both the widths of the first dam 4 and the second dam 5 generally need to be set between 30 µm and 40 µm.

However, in the embodiments of the present application, since the middle of the dam structure 20 is provided with a groove with relatively small space, there is less room for the film layer material to flow towards the groove when forming the second dam layer 22 and the third dam layer 23 on the first dam layer 21. This reduces the flow range of the film layer material, making it easier to form the second dam layer 22 and the third dam layer 23 in the dam structure 20. Consequently, the length of the dam structure 20 in the direction parallel to the substrate 10 can be made smaller, and less than 30 µm, further reducing the width of the transition region 103 and increasing the screen-to-body ratio.

Optionally, in order to ensure the blocking effect of the dam structure 20 on the material of the organic encapsulation sub-layer, the length of the dam structure 20 in the direction parallel to the substrate 10 needs to be greater than or equal to 20 µm.

In an embodiment, the first dam layer 21 may have the same film layer structure as the planarization layer in the display portion 31, and be formed together with the planarization layer using the same mask; the second dam layer 22 may have the same film layer structure as the pixel definition layer in the display portion 31, and be formed together with the pixel definition layer using the same mask; the third dam layer 23 may have the same film layer structure as the spacer layer in the display portion 31, and be formed together with the spacer layer using the same mask.

In another embodiment of the present application, referring to FIG. 2 and FIG. 5, the difference between this embodiment and the embodiment shown in FIG. 4 is that the second dam layer 22 is provided with a second opening 220 located in the recessed sub-region 202, the second opening 220 is communicated with the first opening 210, and the third dam layer 23 covers both the first opening 210 and the second opening 220.

Compared with the embodiment shown in FIG. 4, this embodiment increases the depth of the groove in the dam structure 20, thereby improving the blocking effect of the dam structure 20 on the film layer material of the organic encapsulation sub-layer.

In another embodiment of the present application, referring to FIG. 2 and FIG. 6, the difference between this embodiment and the embodiment shown in FIG. 4 is that the third dam layer 23 is provided with a third opening 230 located in the recessed sub-region 202, and the second dam layer 22 is spaced between the third opening 230 and the substrate 10.

Specifically, the second dam layer 22 covers the sidewall of the first dam layer 21 and the first opening 210, the third dam layer 23 covers the sidewall of the second dam layer 22, and the bottom of the third opening 230 exposes part of the upper surface of the second dam layer 22.

In another embodiment of the present application, referring to FIG. 2 and FIG. 7, the difference between this embodiment and the embodiment shown in FIG. 4 is that the first dam layer 21 includes a plurality of sub-layers, and the first opening 210 in the first dam layer 21 passes through part or all of the plurality of sub-layers.

Specifically, the first dam layer 21 includes a first sub-layer 211 and a second sub-layer 212 that are arranged in a stacked configuration. The first sub-layer 211 is disposed between the second sub-layer 212 and the substrate 10, and the first opening 210 passes through both the first sub-layer 211 and the second sub-layer 212.

It can be understood that, correspondingly, the planarization layer in the display portion 31 is also a stacked structure of a plurality of planarization sub-layers, and the number of the plurality of planarization sub-layers may be the same as the number of the plurality of sub-layers in the first dam layer 21.

In other embodiments, the first opening 210 may pass through any one of the first sub-layer 211 and the second sub-layer 212, and the first dam layer 21 may further include more sub-layers, which is not limited herein.

In another embodiment of the present application, referring to FIG. 2, FIG. 8, and FIG. 9, the difference between this embodiment and the embodiment shown in FIG. 4 is that the first dam layer 21 is disposed on a side of the second dam layer 22 that is away from the third dam layer 23, the third dam layer 23 is disposed between the substrate 10 and the second dam layer 22, the first dam layer 21 is provided with a first opening 210 located in the recessed sub-region 202, and both the second dam layer 22 and the third dam layer 23 are spaced between the first opening 210 and the substrate 10.

The third dam layer 23 may have the same film layer structure as the planarization layer in the display portion 31, and be formed together with the planarization layer using the same mask; the second dam layer 22 may have the same film layer structure as the pixel definition layer in the display portion 31, and be formed together with the pixel definition layer using the same mask; the first dam layer 21 may have the same film layer structure as the spacer layer in the display portion 31, and be formed together with the spacer layer using the same mask.

In this embodiment, the first opening 210 is the groove in the dam structure 20. During the manufacturing process, after sequentially forming the first dam layer 21, the second dam layer 22, and the third dam layer 23 that are stacked on the substrate 10, a mask 40 may be provided on a side of the third dam layer 23 that is away from the second dam layer 22. The mask 40 may include a first region 41 and a second region 42. The patterning process of the photolithography is achieved based on the difference in light transmittance between the first region 41 and the second region 42, to remove the first dam layer 21 outside the protruding sub-region 201, thereby forming the first opening 210 that is a groove, within the recessed sub-region 202.

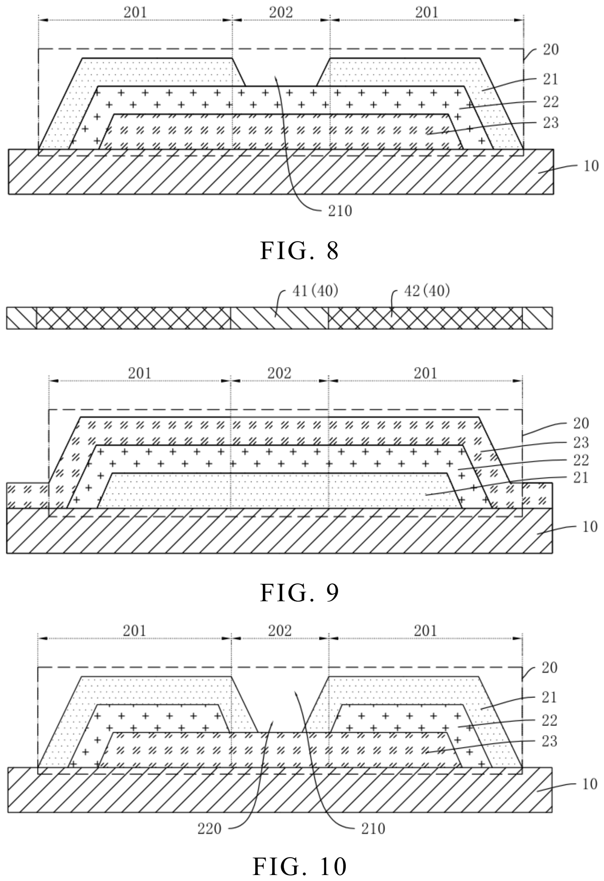

In another embodiment of the present application, referring to FIG. 2 and FIG. 10, the difference between this embodiment and the embodiment shown in FIG. 8 is that the second dam layer 22 is provided with a second opening 220 located in the recessed sub-region 202, the second opening 220 is communicated with the first opening 210, and the third dam layer 23 is spaced between the first opening 210 (the second opening 220) and the substrate 10.

Specifically, the first dam layer 21 covers the sidewall of the second dam layer 22 and the sidewall of the second opening 220, and the length of the first opening 210 in the direction parallel to the substrate 10 is less than the length of the second opening 220 in the direction parallel to the substrate 10.

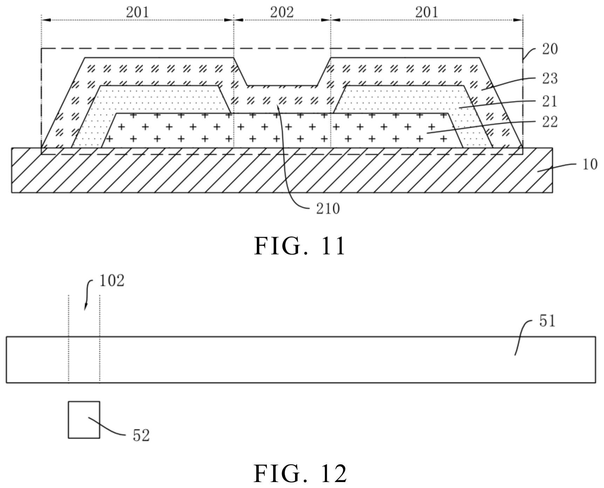

In another embodiment of the present application, referring to FIG. 2 and FIG. 11, the difference between this embodiment and the embodiment shown in FIG. 4 is that the first dam layer 21 is disposed between the second dam layer 22 and the third dam layer 23, and the second dam layer 22 is disposed between the substrate 10 and the first dam layer 21.

The second dam layer 22 may have the same film layer structure as the planarization layer in the display portion 31, and be formed together with the planarization layer using the same mask; the first dam layer 21 may have the same film layer structure as the pixel definition layer in the display portion 31, and be formed together with the pixel definition layer using the same mask; the third dam layer 23 may have the same film layer structure as the spacer layer in the display portion 31, and be formed together with the spacer layer using the same mask.

Further, the second dam layer 22 is spaced between the first opening 210 and the substrate 10, and the third dam layer 23 covers the first dam layer 21 and the first opening 210.

In other embodiments of the present application, the display panel further includes a bezel region (not shown in the figures) adjacent to the surrounding display region 101. The dam structure 20 may also be disposed in the bezel region, surrounding the display region 101. It similarly serves as a barrier for the organic encapsulation sub-layer, ensuring that the organic encapsulation sub-layer is confined to the side of the dam structure 20 that is close to the display region 101.

It should be noted that, in the embodiments of the present application, the dam structure 20 may further include a plurality of protruding sub-regions 201 and a plurality of recessed sub-regions 202. The plurality of protruding sub-regions 201 and the plurality of recessed sub-regions 202 are alternately arranged. That is, a protruding sub-region 201 is adjacent to a recessed sub-region 202, a recessed sub-region 202 may be spaced between two protruding sub-regions 201, and a protruding sub-region 201 may be spaced between two recessed sub-regions 202. The heights of the dam structure 20 in different protruding sub-regions 201 may be the same or different. Similarly, the heights of the dam structure 20 in different recessed sub-regions 202 may be the same or different. However, the height of the dam structure 20 within any protruding sub-region 201 is greater than the height of the dam structure 20 within any recessed sub-region 202.

Based on the above, the embodiments of the present application differentiate the number of dam layers within the protruding sub-region 201 and the recessed sub-region 202 of the dam structure 20. It selectively removes part of the dam layers within the recessed sub-region 202 to form a concave-convex morphology in the dam structure 20. This allows the dam structure 20 to provide a blocking effect on the film layer material that is comparable to the blocking effect of more than one dam in related art. At the same time, in the embodiments of the present application, part dam layers in the dam structure 20 can be etched to selectively remove certain dam layers within the recessed sub-region 202. Compared to related art, this approach does not require etching all the film layers, reducing the number of etching processes and thereby minimizing the impact of precision fluctuations in the etching process. This eliminates the need to reserve a large space to buffer the impact of etching process precision fluctuations, allowing for a reduction in the width of the recessed sub-region 202 and the width of the dam structure 20, which in turn reduces the width of the transition region 103 and increases the screen-to-body ratio of the display panel.

Additionally, some embodiments of the present application further provide a display apparatus, which includes the display panel described in any one of the above-mentioned embodiments.

In an embodiment, referring to FIG. 12, the display apparatus includes a display panel 51 and a sensor 52 that is disposed on a side of the display panel 51. The sensor 52 is disposed corresponding to the sensor photosensitive region 102 of the display panel 51.

The display apparatus may be a display apparatus such as a mobile phone, a television, a computer, a tablet, or a watch.

In the above-mentioned embodiments, the description of each embodiment has its own emphasis, and the parts not described in detail in a certain embodiment may be referred to the related description of other embodiments.

The display panel and the display apparatus provided by the embodiments of the present application are described in detail above, specific examples are used herein to explain the principles and implementations of the present application, and the description of the above embodiments is only used to help understand the technical solutions of the present application and the core idea thereof. Those of ordinary skill in the art should understand that they can still modify the technical solutions described in the foregoing embodiments or equivalently replace some of the technical features therein; and these modifications or substitutions do not make the essence of the corresponding technical solutions deviate from the scope of the technical solutions of the embodiments of the present application.

## Claims

1. A display panel, comprising a display region, a sensor photosensitive region, and a transition region located between the display region and the sensor photosensitive region;
wherein the display panel further comprises:
a substrate; and
a display functional layer disposed on the substrate, wherein the display functional layer comprises a display portion disposed in the display region and a dam structure disposed in the transition region, wherein the dam structure comprises dam layers;
wherein the dam structure comprises a protruding sub-region and a recessed sub-region connected to each other, and the dam layers are disposed in both the recessed sub-region and the protruding sub-region; the number of the dam layers in the recessed sub-region is greater than or equal to 1 and less than the number of the dam layers in the protruding sub-region, and a height of the dam structure in the recessed sub-region is less than a height of the dam structure in the protruding sub-region.

2. The display panel according to claim 1, wherein the dam layers comprise a first dam layer, a second dam layer, and a third dam layer arranged in a stacked configuration, wherein the first dam layer is provided with a first opening located in the recessed sub-region.

3. The display panel according to claim 2, wherein the first dam layer is disposed between the substrate and the second dam layer, and the third dam layer is disposed on a side of the second dam layer away from the first dam layer, wherein the second dam layer and/or the third dam layer covers the first opening.

4. The display panel according to claim 3, wherein the second dam layer is provided with a second opening located in the recessed sub-region and communicated with the first opening, and the third dam layer covers both the first opening and the second opening;
or the second dam layer covers the first opening, and the third dam layer is provided with a third opening disposed on a side of the second dam layer away from the substrate and located in the recessed sub-region;
or both the second dam layer and the third dam layer cover the first opening.

5. The display panel according to claim 2, wherein the first dam layer is disposed on a side of the second dam layer away from the third dam layer, the third dam layer is disposed between the substrate and the second dam layer, and at least the third dam layer is spaced between the first opening and the substrate.

6. The display panel according to claim 5, wherein the second dam layer is provided with a second opening located in the recessed sub-region and communicated with the first opening.

7. The display panel according to claim 2, wherein the first dam layer is disposed between the second dam layer and the third dam layer, and the second dam layer is disposed between the substrate and the first dam layer.

8. The display panel according to claim 2, wherein the first dam layer comprises a plurality of sub-layers arranged in a stacked configuration, and the first opening passes through part or all of the plurality of sub-layers.

9. The display panel according to claim 1, wherein the display panel is provided with a light-transmitting hole in the sensor photosensitive region, the dam structure comprises at least two of the protruding sub-regions, and the recessed sub-region is disposed between adjacent ones of the protruding sub-regions, wherein the dam structure is disposed around the light-transmitting hole, and the recessed sub-region is disposed around the light-transmitting hole.

10. The display panel according to claim 9, further comprising an encapsulation layer, wherein the encapsulation layer comprises at least two inorganic encapsulation sub-layers and an organic encapsulation sub-layer disposed between two adjacent ones of the at least two inorganic encapsulation sub-layers, wherein,
wherein a coverage boundary of the organic encapsulation sub-layer is located within the recessed sub-region, or within one of the protruding sub-regions, or at a side of the dam structure away from the light-transmitting hole.

11. A display apparatus, comprising a display panel, wherein the display panel comprises a display region, a sensor photosensitive region, and a transition region located between the display region and the sensor photosensitive region;
wherein the display panel further comprises:
a substrate; and
a display functional layer disposed on the substrate, wherein the display functional layer comprises a display portion disposed in the display region and a dam structure disposed in the transition region, wherein the dam structure comprises dam layers;
wherein the dam structure comprises a protruding sub-region and a recessed sub-region connected to each other, and the dam layers are disposed in both the recessed sub-region and the protruding sub-region; the number of the dam layers in the recessed sub-region is greater than or equal to 1 and less than the number of the dam layers in the protruding sub-region, and a height of the dam structure in the recessed sub-region is less than a height of the dam structure in the protruding sub-region.

12. The display apparatus according to claim 11, wherein the dam layer comprises a first dam layer, a second dam layer, and a third dam layer arranged in a stacked configuration, wherein the first dam layer is provided with a first opening located in the recessed sub-region.

13. The display apparatus according to claim 12, wherein the first dam layer is disposed between the substrate and the second dam layer, and the third dam layer is disposed on a side of the second dam layer away from the first dam layer, wherein the second dam layer and/or the third dam layer covers the first opening.

14. The display apparatus according to claim 13, wherein the second dam layer is provided with a second opening located in the recessed sub-region and communicated with the first opening, and the third dam layer covers both the first opening and the second opening;
or the second dam layer covers the first opening, and the third dam layer is provided with a third opening disposed on a side of the second dam layer away from the substrate and located in the recessed sub-region;
or both the second dam layer and the third dam layer cover the first opening.

15. The display apparatus according to claim 12, wherein the first dam layer is disposed on a side of the second dam layer away from the third dam layer, the third dam layer is disposed between the substrate and the second dam layer, and at least the third dam layer is spaced between the first opening and the substrate.

16. The display apparatus according to claim 15, wherein the second dam layer is provided with a second opening located in the recessed sub-region and communicated with the first opening.

17. The display apparatus according to claim 12, wherein the first dam layer is disposed between the second dam layer and the third dam layer, and the second dam layer is disposed between the substrate and the first dam layer.

18. The display apparatus according to claim 12, wherein the first dam layer comprises a plurality of sub-layers arranged in a stacked configuration, and the first opening passes through part or all of the plurality of sub-layers.

19. The display apparatus according to claim 11, wherein the display panel is provided with a light transmitting hole in the sensor photosensitive region, the dam structure comprises at least two of the protruding sub-regions, and the recessed sub-region is disposed between adjacent ones of the protruding sub-regions, wherein the dam structure is disposed around the light transmitting hole, and the recessed sub-region is disposed around the light transmitting hole.

20. The display apparatus according to claim 19, wherein the display panel further comprises an encapsulation layer, and the encapsulation layer comprises at least two inorganic encapsulation sub-layers and an organic encapsulation sub-layer disposed between two adjacent ones of the at least two inorganic encapsulation sub-layers, wherein,
wherein a coverage boundary of the organic encapsulation sub-layer is located within the recessed sub-region, or within one of the protruding sub-regions, or at a side of the dam structure away from the light-transmitting hole.
